# FASCICULE DE BREVET EUROPEEN

(11) **EP 2 849 195 B1**
(45) Date de publication et mention de la délivrance du brevet: **16.03.2016**
(21) Numéro de dépôt: 14184385.4
(22) Date de dépôt: 11.09.2014
(51) Int. Cl.: H01H 71/04, H01H 9/16, G01R 31/327, H01H 71/02, H01H 71/10, H01H 47/00

(54) **Appareil auxiliaire pour disjoncteur électrique, système électrique comportant un disjoncteur et un tel appareil auxiliaire et procédé de détermination d'une cause de l'ouverture du disjoncteur à l'aide d'un tel appareil auxiliaire**
Zusatzvorrichung für elektrischen Schutzschalter, elektrisches System mit einem Schutzschalter und dieser Zusatzvorrichtung und Verfahren zur Bestimmung des Grunds der Öffnung des Schutzshalters dank dieser Zusatzvorrichtung
Auxiliary device for electric circuit breaker, electrical system comprising a circuit breaker and such an auxiliary device and method to determine the ground of the circuit breaker opening with such an auxiliary device

(30) Priorité: 12.09.2013 FR 1358773
(43) Date de publication de la demande: 18.03.2015
(73) Titulaire: Schneider Electric Industries SAS, 92500 Rueil-Malmaison (FR)
(72) Inventeur: Michaux, Marie-Laure, 38050 Grenoble Cedex 09 (FR); Heraud, Sébastien, 38050 Grenoble Cedex 09 (FR); Brasme, Frédéric, 38050 Grenoble Cedex 09 (FR); Urankar, Lionel, 38050 Grenoble Cedex 09 (FR)
(74) Mandataire: Myon, Gérard Jean-Pierre

(56) Documents cités:
- EP-A1- 1 814 133
- US-A1- 2009 090 604
- US-A1- 2010 277 846
- US-A1- 2013 197 835

## Description

La présente invention concerne un appareil auxiliaire pour disjoncteur électrique, le disjoncteur électrique étant, en position ouverte, propre à interrompre la circulation d'un courant dans une liaison électrique, la liaison électrique comportant au moins un conducteur électrique, le disjoncteur électrique comportant un organe mécanique de sortie, mobile entre une position d'opération et une position d'arrêt correspondant à l'interruption de la circulation du courant dans ladite liaison électrique suite à une ouverture du disjoncteur.

L'appareil auxiliaire comprend un moyen de couplage mécanique avec l'organe mécanique de sortie, le moyen de couplage mécanique formant moyen de détection de l'ouverture du disjoncteur.

La présente invention concerne également un système électrique comprenant un disjoncteur électrique et un tel appareil auxiliaire couplé mécaniquement au disjoncteur électrique.

La présente invention concerne également un procédé de détermination d'une cause de l'ouverture du disjoncteur électrique à l'aide d'un tel appareil auxiliaire.

On connaît un appareil auxiliaire du type précité. Un tel appareil auxiliaire est également appelé auxiliaire de contact, et comporte un premier moyen de couplage avec une barre de déclenchement du disjoncteur et un deuxième moyen de couplage avec une manette d'actionnement du disjoncteur. Il permet alors de savoir si le disjoncteur est ouvert suite à un actionnement manuel de la manette, l'état du disjoncteur étant alors également appelé état ouvert, ou bien suite à la présence d'un défaut, tel qu'une surcharge électrique, sur la liaison électrique ayant provoqué le déclenchement du disjoncteur l'état du disjoncteur étant alors également appelé état déclenché sur défaut. Lorsque le disjoncteur est en position de fermeture, l'état du disjoncteur est également appelé état fermé.

Un appareil auxiliaire est également connu du document US 2009/090604.

Toutefois, un tel appareil auxiliaire ne permet de connaitre que les états ouvert, fermé ou déclenché sur défaut et ne permet pas de connaitre plus précisément une cause d'une ouverture du disjoncteur électrique auquel il est associé.

Le but de l'invention est donc de proposer un appareil auxiliaire pour disjoncteur électrique permettant une meilleure surveillance dudit disjoncteur électrique, notamment la détermination de la cause d'une ouverture du disjoncteur électrique auquel l'appareil auxiliaire est couplé mécaniquement.

A cet effet, l'invention a pour objet un appareil auxiliaire du type précité, caractérisé en ce qu'il comprend en outre au moins un capteur de courant propre à mesurer l'intensité du courant circulant dans un conducteur électrique respectif, et un dispositif de détermination d'une cause de l'ouverture détectée, en fonction de l'intensité mesurée par le ou chaque capteur de courant, le dispositif de détermination étant relié au moyen de couplage mécanique et au capteur de courant.

Suivant d'autres aspects avantageux de l'invention, l'appareil auxiliaire comprend une ou plusieurs des caractéristiques suivantes, prises isolément ou suivant toutes les combinaisons techniquement possibles :
- le dispositif de détermination comprend un moyen de comparaison, avec au moins une valeur de seuil prédéterminée, de l'intensité mesurée par le ou chaque capteur de courant ;
- le moyen de comparaison est propre à comparer l'intensité mesurée avec une première valeur de seuil afin de déterminer une première cause d'ouverture et avec une deuxième valeur de seuil afin de déterminer une deuxième cause d'ouverture ;
- le dispositif de détermination comprend un moyen de calcul d'une durée pendant laquelle l'intensité mesurée est supérieure à la valeur de seuil prédéterminée ;
- le dispositif de détermination comprend un moyen de datation du ou des dépassements de la valeur de seuil prédéterminée par l'intensité mesurée et une mémoire de stockage des dates du ou desdits dépassements ;
- le disjoncteur électrique comprend deux organes mécaniques de sortie, un premier organe parmi les deux organes mécaniques de sortie étant mobile en position d'arrêt en cas de surcharge sur la liaison électrique et le deuxième organe étant mobile en position d'arrêt en cas de surcharge sur la liaison électrique ou d'actionnement manuel du disjoncteur électrique, dans lequel l'appareil auxiliaire comprend deux moyens de couplage mécanique, un premier moyen parmi les deux moyens de couplage étant couplé mécaniquement avec le premier organe de sortie et le deuxième moyen étant couplé mécaniquement avec le deuxième organe de sortie, et dans lequel le dispositif de détermination est relié aux premier et deuxième moyens de couplage mécanique, la cause de l'ouverture étant déterminée en outre en fonction de la position du premier organe mécanique de sortie et de la position du deuxième organe mécanique de sortie ; et
- l'appareil auxiliaire comprend en outre un capteur de courant différentiel, et le dispositif de détermination est propre à déterminer la cause de d'ouverture en fonction de l'intensité mesurée par le ou chaque capteur de courant et du courant différentiel mesuré par le capteur de courant différentiel.

L'invention a également pour objet un système électrique comprenant un disjoncteur électrique et un appareil auxiliaire couplé mécaniquement au disjoncteur électrique, le disjoncteur électrique étant, en position ouverte, propre à interrompre la circulation d'un courant électrique dans une liaison électrique, la liaison électrique comportant au moins un conducteur électrique, le disjoncteur électrique comportant un organe mécanique de sortie mobile entre une position d'opération et une position d'arrêt correspondant à l'interruption de la circulation du courant dans ladite liaison électrique, caractérisé en ce que l'appareil auxiliaire est tel que défini ci-dessus.

Suivant un autre aspect avantageux de l'invention, le système électrique comprend la caractéristique suivante :
- le système électrique comprend en outre un déclencheur différentiel disposé entre le disjoncteur électrique et l'appareil auxiliaire, l'appareil auxiliaire étant couplé mécaniquement à l'organe mécanique de sortie du disjoncteur électrique.

L'invention a également pour objet un procédé de détermination d'une cause d'une ouverture d'un disjoncteur électrique à l'aide d'un appareil auxiliaire, le disjoncteur électrique étant, en position ouverte, propre à interrompre la circulation d'un courant électrique dans une liaison électrique, la liaison électrique comportant au moins un conducteur, le disjoncteur électrique comportant un organe mécanique de sortie, mobile entre une position d'opération et une position d'arrêt correspondant à l'interruption de la circulation du courant dans ladite liaison électrique, l'appareil auxiliaire comprenant un moyen de couplage mécanique avec l'organe mécanique de sortie,
le procédé comprenant l'étape suivante :
- la détection, via le moyen de couplage mécanique, de l'ouverture du disjoncteur électrique, et
le procédé étant caractérisé en ce qu'il comprend en outre les étapes suivantes :
- la mesure, par l'appareil auxiliaire, de l'intensité du courant circulant dans le ou chaque conducteur, l'appareil comportant en outre un capteur de courant pour chaque conducteur électrique, et
- la détermination, par l'appareil auxiliaire et en fonction de l'intensité mesurée par le ou chaque capteur de courant, d'une cause de l'ouverture détectée.

Suivant un autre aspect avantageux de l'invention, le procédé de détermination comprend la caractéristique suivante :
le disjoncteur électrique comprend deux organes mécaniques de sortie, un premier organe parmi les deux organes mécaniques de sortie étant mobile en position d'arrêt en cas de surcharge sur la liaison électrique et le deuxième organe étant mobile en position d'arrêt en cas de surcharge sur la liaison électrique ou d'actionnement manuel du disjoncteur électrique,
dans lequel l'appareil auxiliaire comprend deux moyens de couplage mécanique, un premier moyen parmi les deux moyens de couplage étant couplé mécaniquement avec le premier organe de sortie et le deuxième moyen étant couplé mécaniquement avec le deuxième organe de sortie, et
dans lequel, lors de l'étape de détermination, la cause de l'ouverture est déterminée en outre en fonction de la position du premier organe mécanique de sortie et de la position du deuxième organe mécanique de sortie.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un système électrique selon l'invention comprenant un disjoncteur électrique, un déclencheur différentiel et un appareil auxiliaire couplé mécaniquement audit disjoncteur et audit déclencheur différentiel,
- la figure 2 est une représentation très schématique de l'appareil auxiliaire de la figure 1,
- la figure 3 est un organigramme d'un procédé de détermination, selon un premier mode de réalisation, d'une cause d'une ouverture détectée pour le disjoncteur de la figure 1,
- la figure 4 est une courbe de déclenchement du disjoncteur,
- les figures 5 et 6 sont des vues analogues à celle de la figure 3 selon une première variante et respectivement une deuxième variante de réalisation du procédé de détermination selon le premier mode de réalisation,
- la figure 7 est un organigramme du procédé de détermination selon un deuxième mode de réalisation,
- les figures 8 et 9 sont des vues analogues à celle de la figure 7 selon une première variante et respectivement une deuxième variante de réalisation du procédé de détermination selon le deuxième mode de réalisation, et
- la figure 10 est une représentation schématique du système électrique selon un troisième mode de réalisation, et
- les figures 11 et 12 sont des vues analogues à celle de la figure 10 selon un quatrième et un cinquième mode de réalisation.

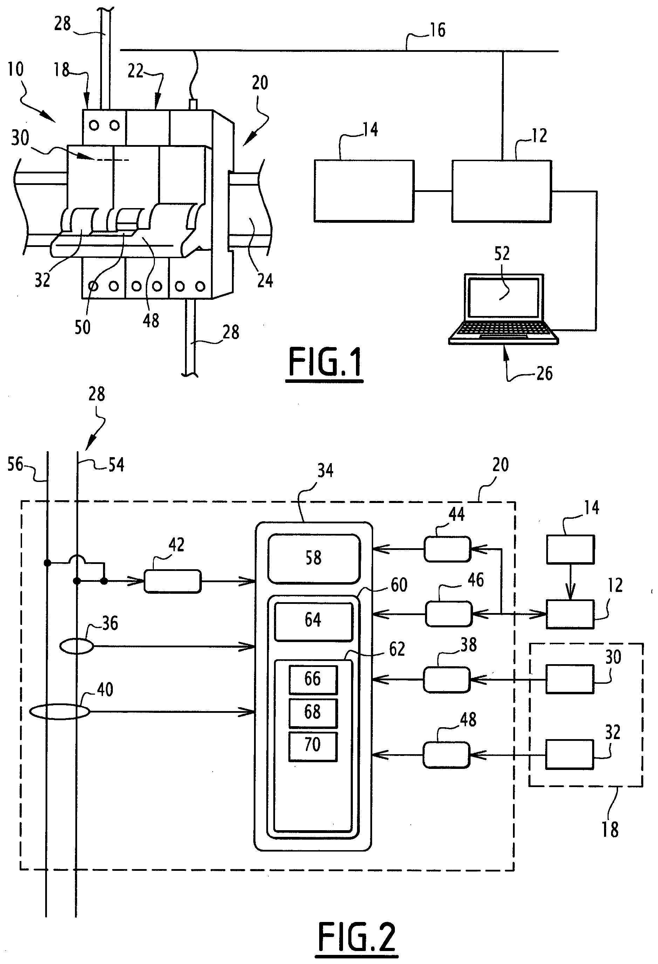

Sur la figure 1, un système électrique 10 est relié à un concentrateur de données 12 et à un dispositif d'alimentation électrique 14 par une liaison 16.

Le système électrique 10 comprend un disjoncteur électrique 18, tel qu'un disjoncteur électromécanique, de préférence un disjoncteur magnétothermique, et un appareil auxiliaire 20 couplé mécaniquement au disjoncteur électrique 18.

En complément, dans l'exemple de réalisation de la figure 1, le système électrique 10 comprend un appareil électrique 22, tel qu'un déclencheur différentiel, également appelé Vigi, disposé entre le disjoncteur 18 et l'appareil auxiliaire 20, l'appareil auxiliaire 20 étant toujours couplé mécaniquement au disjoncteur 18.

Le système électrique 10 comprend un rail 24 sur lequel sont agencés le disjoncteur 18, l'appareil auxiliaire 20 et le déclencheur différentiel 22.

Le concentrateur de données 12 est propre à recevoir, de la part de l'appareil auxiliaire 20 via la liaison 16, des informations relatives au fonctionnement du disjoncteur 18.

Le concentrateur de données 12 est relié à un dispositif de visualisation 26, afin d'afficher notamment les informations relatives au fonctionnement du disjoncteur 18.

Le dispositif d'alimentation électrique 14 est propre à alimenter en énergie électrique l'appareil auxiliaire 20 via la liaison 16. La tension électrique délivrée par le dispositif d'alimentation 14 est, par exemple, une tension continue sensiblement égale à 24 V.

La liaison 16 est une liaison permettant de transmettre à la fois des données et l'énergie électrique, les données étant propres à être transmises de manière bidirectionnelle entre le concentrateur de données 12 et l'appareil auxiliaire 20, et l'énergie électrique étant délivrée par le dispositif d'alimentation 14.

Dans l'exemple de réalisation de la figure 1, la liaison 16 est une liaison filaire. La liaison 16 est, par exemple, conforme au protocole de communication IO-Link.

Le disjoncteur électrique 18 est connu en soi et est propre à interrompre la circulation d'un courant électrique dans une liaison électrique 28, visible sur la figure 2, notamment en présence d'un défaut sur la liaison électrique 28.

Le disjoncteur 18 comporte un premier organe mécanique de sortie 30, représenté de manière schématique sur la figure 2, et un deuxième organe mécanique de sortie 32, visible sur la figure 1, chaque organe mécanique de sortie 30, 32 étant mobile entre une position d'opération et une position d'arrêt correspondant à l'interruption de la circulation du courant dans ladite liaison électrique 28 suite à une ouverture du disjoncteur. Le premier organe mécanique de sortie 30 est mobile en position d'arrêt en cas de surcharge sur la liaison électrique 28. Le deuxième organe mécanique de sortie 32 est mobile en position d'arrêt en cas de surcharge sur la liaison électrique 28 ou au manuel du disjoncteur électrique 18.

Le disjoncteur électrique 18 est, par exemple, un disjoncteur magnétothermique propre à interrompre la circulation du courant dans la liaison électrique 28 dans le cas d'une surcharge par effet thermique et dans le cas d'un court-circuit par effet magnétique.

L'appareil auxiliaire 20 comprend une unité de traitement d'informations 34, un capteur de courant 36, tel qu'un capteur de courant de phase dans le cas d'un courant alternatif, et un premier moyen 38 de couplage mécanique avec le premier organe mécanique de sortie 30.

En complément dans le cas d'un courant alternatif, l'appareil auxiliaire 20 comprend un capteur de courant différentiel 40 propre à mesurer un courant différentiel de la liaison électrique 28.

L'appareil auxiliaire 20 comprend un capteur 42 de mesure de la tension de la liaison électrique 28, un convertisseur 44 d'un courant continu en un autre courant continu et un module de communication 46.

En complément, l'appareil auxiliaire 20 comprend un deuxième moyen 48 de couplage mécanique avec le deuxième organe mécanique de sortie 32, comme représenté sur la figure 1.

Le déclencheur différentiel 22 est fixé sur le rail 24 entre le disjoncteur 18 et l'appareil auxiliaire 20. Le déclencheur différentiel 22 comporte une ouverture, non représentée, de passage d'un organe de liaison mécanique entre le premier organe mécanique de sortie 30 et le premier moyen de couplage 38.

Le déclencheur différentiel 22 comporte une manette 50 de réarmement du disjoncteur, la manette de réarmement 50 n'étant pas couplée mécaniquement au deuxième moyen de couplage 48.

Le déclencheur différentiel électrique 22 est propre à limiter les risques d'électrocution en détectant des fuites de courant vers une masse électrique.

Le rail 24 est par exemple un rail DIN (de l'allemand *Deutsches Institut für Normung).*

Le dispositif de visualisation 26 comporte notamment un écran d'affichage 52 et des moyens, non représentés, d'affichage à l'écran de données reçues du concentrateur de données 12.

La liaison électrique 28, visible sur la figure 2, comporte un premier conducteur électrique 54, tel qu'un conducteur de phase ou encore un conducteur de potentiel continu positif et un deuxième conducteur électrique 56, tel qu'un conducteur de neutre ou encore un conducteur de potentiel continu de référence.

Le premier organe mécanique de sortie 30 est connu en soi, et est également appelé barre de déclenchement. La barre de déclenchement 30 est mobile entre sa position d'opération, et sa position d'arrêt correspondant à un état déclenché du disjoncteur 18, cet état étant également appelé déclenché sur défaut, c'est-à-dire l'état dans lequel se trouve le disjoncteur 18 après un déclenchement dû à un défaut, tel qu'un court-circuit ou une surcharge électrique, ce déclenchement provoquant l'interruption de la circulation du courant dans la liaison électrique 28 afin d'isoler ledit défaut électrique. La position d'opération du premier organe mécanique de sortie 30 correspond à un état fermé du disjoncteur 18, c'est-à-dire l'état permettant la circulation du courant dans la liaison électrique 28, ou à un état ouvert du disjoncteur 18, c'est-à-dire l'état dans lequel se trouve le disjoncteur 18 après avoir été ouvert manuellement. L'état ouvert du disjoncteur 18 correspond à une interruption de la circulation du courant dans la liaison électrique 28.

Le deuxième organe mécanique de sortie 32 est distinct du premier organe mécanique de sortie 30. Le deuxième organe mécanique de sortie 32 est connu en soi, et est également appelé manette 32 de réarmement du disjoncteur. La manette de réarmement 32 permet de réarmer le disjoncteur 18 après un déclenchement, c'est-à-dire de faire passer le disjoncteur 18 de son état ouvert à son état fermé, afin de laisser à nouveau le courant circuler dans la liaison électrique 28. La manette 32 permet également d'ouvrir manuellement le disjoncteur 18. La manette de réarmement 32 est mobile entre sa position d'opération correspondant à l'état fermé du disjoncteur 18 et sa position d'arrêt correspondant à l'état ouvert du disjoncteur 18 en cas d'actionnement manuel de celui-ci, ou encore à l'état déclenché du disjoncteur 18 en cas de surcharge ou de court-circuit sur la liaison électrique.

L'unité de traitement d'informations 34 comporte un processeur 58 et une mémoire 60 associée au processeur 58. La mémoire 60 est apte à stocker une application 62 de détermination de la cause d'une ouverture détectée en fonction de l'intensité mesurée par le capteur de courant de phase 36. La mémoire 60 est également apte à stocker un logiciel 64 d'échantillonnage de l'intensité mesurée par le capteur de courant de phase 36, du courant différentiel mesuré par le capteur de courant différentiel 40 et de la tension mesurée par le capteur de tension 42. La mémoire 60 est également apte à stocker des échantillons de mesure d'intensité mesurés par les capteurs de courant 36, 40 et aussi de tension mesurée par le capteur de tension 42, ainsi qu'à mémoriser les positions des organes mécaniques 30, 32 du disjoncteur.

Le capteur de courant 36 est connu en soi et est propre à mesurer l'intensité I du courant circulant dans le conducteur électrique 54. Le capteur de courant 36 est par exemple un capteur de courant de phase, et comporte alors, par exemple, un tore de Rogowski, un shunt ou encore un capteur à effet Hall.

Le premier moyen de couplage mécanique 38 forme un moyen de détection d'un déclenchement sur défaut du disjoncteur 18. Le premier moyen de couplage 38 comporte une interface mécanique avec le premier organe mécanique de sortie 30.

Le capteur de courant différentiel 40 est connu en soi et est, par exemple, en forme d'un tore entourant à la fois le conducteur 54 et le conducteur 56, comme représenté sur la figure 2.

Le capteur de tension 42 est propre à mesurer la tension du conducteur 54 par rapport au conducteur 56.

Le convertisseur continu-continu 44 est propre à convertir la tension continue reçue du dispositif d'alimentation 14 en une autre tension continue de plus faible valeur apte à alimenter le microprocesseur 34. Le convertisseur continu-continu 44 est, par exemple, propre à convertir une tension continue de l'ordre de 24 V en une tension continue de l'ordre de 5 V.

Le module de communication 46 est apte à recevoir des données via la liaison filaire 16 afin de les transmettre ensuite à l'unité de traitement d'informations 34 et/ou à émettre des données issues de l'unité de traitement d'informations 34 à destination du concentrateur de données 12 via la liaison filaire 16.

En variante, le module de communication 46 est apte à communiquer avec le concentrateur de données 12 via une liaison radioélectrique de données.

Le deuxième moyen de couplage mécanique 48 forme un moyen de détection de l'ouverture ou de la fermeture du disjoncteur 18, l'ouverture du disjoncteur 18 correspondant à l'état ouvert ou bien à l'état déclenché sur défaut dudit disjoncteur 18.

Le deuxième moyen de couplage 48 est en forme d'une manette prolongée par un bras présentant une section transversale en forme de U, le bras coopérant avec la manette de réarmement 32 du disjoncteur 18 de par sa section en forme de U. Le deuxième moyen de couplage 48 ne coopère pas avec la manette 50 de réarmement du déclencheur différentiel laquelle manette 50 est laissée libre par rapport au deuxième moyen de couplage 48.

La manette de réarmement 50 du déclencheur différentiel est connue en soi et analogue à celle du disjoncteur 18. Elle permet de réarmer le déclencheur différentiel 22 après un déclenchement, c'est-à-dire de faire passer le déclencheur différentiel 22 de son état déclenché à son état enclenché.

L'application de détermination 62 est propre à déterminer la cause d'une ouverture détectée en fonction de l'intensité I mesurée par le capteur de courant 36 et de la position du premier organe mécanique 30 et/ou du deuxième organe mécanique 32.

En complément, lorsque l'appareil auxiliaire 20 comporte également un capteur de courant différentiel 40, l'application de détermination 62 est propre à déterminer la cause de l'ouverture en fonction de l'intensité I mesurée par le capteur de courant 36 et du courant différentiel Id mesuré par le capteur de courant différentiel 40.

L'application de détermination 62 comprend un logiciel 66 de comparaison, avec au moins une valeur de seuil prédéterminée S1, S2, de l'intensité I mesurée par le capteur de courant 36.

L'application de détermination 62 comporte un logiciel 68 de calcul d'une durée pendant laquelle l'intensité mesurée I est supérieure à la valeur de seuil prédéterminée S1, S2.

En complément, l'application de détermination 62 comporte un logiciel 70 de datation du ou des dépassement(s) de la valeur de seuil prédéterminée S1, S2 par l'intensité mesurée I, ledit ou lesdits dépassement(s) étant propre(s) à être stocké(s) dans la mémoire 60 de l'unité de traitement d'informations.

Le logiciel de comparaison 66 est apte à comparer l'intensité mesurée I avec une première valeur de seuil S1 afin de déterminer une première cause d'ouverture et avec une deuxième valeur de seuil S2 afin de déterminer une deuxième cause d'ouverture.

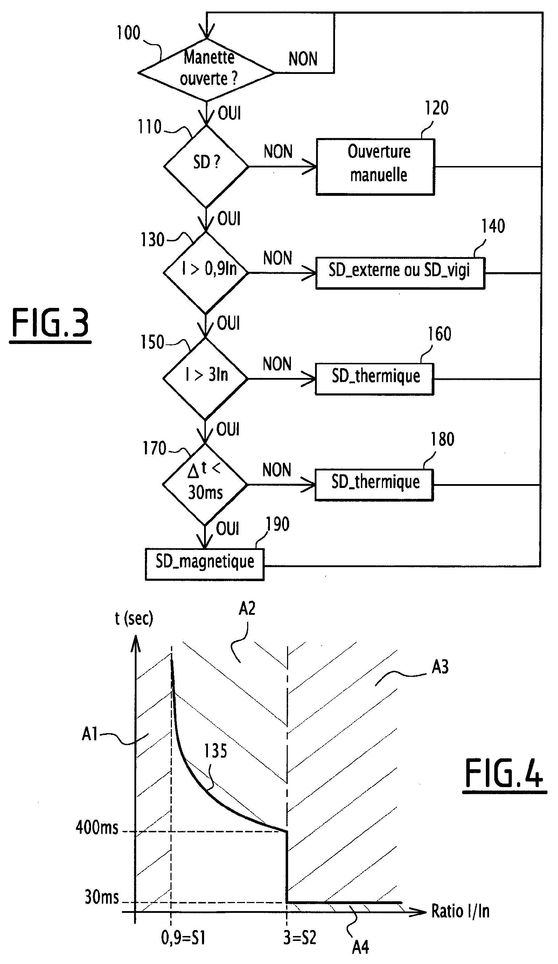

Le fonctionnement du système électrique 10 selon l'invention va désormais être expliqué à l'aide des figures 3 et 4.

Lors de l'étape initiale 100, le deuxième moyen de couplage 48 détecte que le deuxième organe mécanique de sortie 32 est en position basse, également appelée position d'arrêt, c'est-à-dire que la circulation du courant dans la liaison électrique 28 est interrompue par ouverture du disjoncteur 18, et transmettent l'information de l'ouverture détectée à l'unité de traitement d'informations 34. L'unité de traitement d'informations 34 lance alors l'application de détermination 62 afin de déterminer la cause de l'ouverture détectée.

Tant que le deuxième organe mécanique de sortie 32 est en position d'opération, c'est-à-dire en position haute, l'application de détermination 62 reste dans l'étape 100. Lors de cette étape initiale, les valeurs des courant et tension sont régulièrement mesurées par les capteurs 36 et 42, voire par le capteur de courant différentiel 40.

Lors de l'étape suivante 110, après avoir détecté l'ouverture du disjoncteur 18 à l'aide du deuxième moyen de couplage 48, l'application de détermination 62 détermine, à l'aide du premier moyen de couplage 38, la position de la barre de déclenchement 30 afin de savoir si l'ouverture du disjoncteur 18 est due à un déclenchement produit par un défaut électrique ou bien à une ouverture manuelle. En effet, la barre de déclenchement 30 reste en position d'opération lorsque le disjoncteur électrique 18 est déclenché manuellement. Autrement dit, l'étape 110 vise à déterminer si une information de signalisation défaut, également notée SD, est présente, c'est-à-dire si la barre de déclenchement 30 est en position d'arrêt.

Si l'information de signalisation défaut n'est pas présente, c'est-à-dire si la barre de déclenchement 30 est en position d'opération, alors l'application de détermination 62 conclut lors de l'étape 120 que l'ouverture du disjoncteur 18 est due à une ouverture manuelle. Sinon, si l'information SD est présente, c'est-à-dire si la barre de déclenchement 30 est en position d'arrêt, alors l'application de détermination 62 passe à l'étape 130.

Lors de l'étape 130, le logiciel de comparaison 66 compare l'intensité I mesurée par le capteur de courant 36 avec la première valeur de seuil S1 afin de déterminer si l'ouverture du disjoncteur 18 est d'origine externe (manuelle ou auxiliaire) ou due à la détection d'une surcharge ou d'un court-circuit par effet thermique. En fait, il s'agit d'estimer la contrainte thermique dans le temps, soit par intégration sur un intervalle de temps fixe glissant (buffer circulant), soit par comparaison d'une valeur efficace de I à la première valeur de seuil S1.

La première valeur de seuil S1 est fonction de la courbe de déclenchement 135 du disjoncteur 18, visible sur la figure 4. La première valeur de seuil S1 est, par exemple égale à 0,9 fois l'intensité nominale, notée In.

Si le résultat de la comparaison de l'intensité mesurée I avec la première valeur de seuil S1 est négatif, c'est-à-dire si l'intensité mesurée I est inférieure ou égale à la première valeur de seuil S1, par exemple égale à 0,9 x In, alors le disjoncteur 18 se trouve dans une première zone A1, visible sur la figure 4. L'application de détermination 62 en conclut lors de l'étape 140 que l'ouverture du disjoncteur 18 est due à la réception d'un signal de commande du déclenchement, tel qu'une fuite de courant à la terre détectée par le déclencheur différentiel 22 (signal SD_Vigi) ou bien un déclenchement provoqué par un auxiliaire externe au disjoncteur 18 (signal SD_externe).

Sinon, c'est-à-dire si la valeur de l'intensité mesurée I est supérieure à la première valeur de seuil S1, alors l'application de détermination 62 passe à l'étape 150 au cours de laquelle le logiciel de comparaison 66 compare l'intensité mesurée I avec la deuxième valeur de seuil S2.

La deuxième valeur de seuil S2 est également fonction de la courbe de déclenchement 135 du disjoncteur 18, et est par exemple égale à 3 fois l'intensité nominale In.

Si le résultat de la comparaison de l'étape 150 est négatif, c'est-à-dire si l'intensité mesurée est comprise entre la première valeur de seuil S1 et la deuxième valeur de seuil

S2, alors l'application de détermination 62 conclut lors de l'étape 160 que la cause de l'ouverture est une surcharge, le disjoncteur 18 étant alors déclenché par effet thermique, et l'application de détermination 62 renvoie l'information SD_thermique. En effet, lorsque l'intensité mesurée est comprise entre la première valeur de seuil S1 et la deuxième valeur de seuil S2 et que le disjoncteur 18 a été déclenché, alors le disjoncteur 18 se trouve dans une deuxième zone A2, visible sur la figure 4.

Sinon, dans le cas où le résultat de la comparaison avec la deuxième valeur de seuil S2 est positif, c'est-à-dire si l'intensité mesurée est supérieure à la deuxième valeur de seuil S2, par exemple égale à 3 x In, alors l'application de détermination 62 passe à l'étape 170.

Lors de l'étape 170, le logiciel de calcul 68 calcule alors une durée Δt pendant laquelle l'intensité mesurée I a été supérieure à la deuxième valeur de seuil S2 avant la détection de l'ouverture. Si la durée calculée Δt est supérieure à 30 ms, alors le disjoncteur 18 se trouve dans une troisième zone A3, visible sur la figure 4, ce qui correspond à un déclenchement par effet thermique dû à une surcharge. L'application de détermination 62 en conclut alors lors de l'étape 180 que la cause de l'ouverture est une surcharge ayant entraîné un déclenchement par effet thermique et renvoie l'information SD_thermique.

Sinon, si la durée calculée Δt est inférieure à 30 ms, c'est-à-dire si le disjoncteur 18 se trouve dans une quatrième zone A4, visible sur la figure 4, alors l'application de détermination 62 conclut lors de l'étape 190 que l'ouverture du disjoncteur 18 s'est produite via un déclenchement par effet magnétique, le déclenchement par effet magnétique étant bien plus rapide que le déclenchement par effet thermique, et renvoie alors une information SD_magnétique. Dans ce cas, la cause de l'ouverture du disjoncteur 18 est un court-circuit.

A l'issue des étapes 120, 140, 160, 180 ou 190, l'application de détermination 62 retourne à l'étape initiale 100.

L'appareil auxiliaire 20 selon l'invention permet ainsi de déterminer la cause l'ouverture détectée pour le disjoncteur électrique 18 parmi les différentes causes possibles à savoir un court-circuit, une surcharge, un déclenchement externe (manuel ou par un appareil auxiliaire).

Dans l'exemple de réalisation de la figure 3, l'ouverture du disjoncteur 18 est initialement détectée par le deuxième moyen de couplage 48.

En variante, l'ouverture du disjoncteur 18 est initialement détectée par le premier moyen de couplage 38 et le procédé de détermination passe directement à l'étape 130. L'appareil auxiliaire 20 selon l'invention permet alors de déterminer la cause de l'ouverture détectée pour le disjoncteur électrique 18 parmi les différentes causes suivantes : un court-circuit, une surcharge, ou une manoeuvre manuelle de l'appareil.

L'application de détermination 62 renvoie alors l'information correspondant à la cause déterminée de l'ouverture détectée au concentrateur de données 12 afin d'améliorer la supervision du système électrique 10.

L'appareil auxiliaire 20 selon l'invention permet en outre de mesurer le taux de charge du disjoncteur 18 afin de surveiller le risque de déclenchement en surcharge.

En outre, l'appareil auxiliaire 20 selon l'invention permet de mesurer le taux de fuite du disjoncteur 18 à l'aide du capteur de courant différentiel 40 et d'émettre une alarme à destination du concentrateur de données 12 en cas de risque de déclenchement différentiel du déclencheur différentiel 22. De la même manière, le capteur de courant différentiel 40 permet de déterminer si le déclenchement externe a été commandé par le déclencheur différentiel 22.

Lorsque le capteur de courant 36 est un capteur linéaire, tel qu'un tore de Rogowski, un shunt, ou tout autre moyen, la dynamique de mesure est meilleure, ce qui permet d'améliorer la détermination de la cause du déclenchement détecté.

En outre, il n'est pas nécessaire de remplacer le disjoncteur 18, puisque l'appareil auxiliaire 20 selon l'invention se couple mécaniquement au disjoncteur 18 sans modification de celui-ci.

Par ailleurs, la seule liaison entre le disjoncteur 18 et l'appareil auxiliaire 20 étant le couplage mécanique de la barre de déclenchement 30 avec le premier moyen de couplage 38, l'appareil auxiliaire 20 selon l'invention ne perturbe pas les fonctions de protection du disjoncteur 18 et/ou du déclencheur différentiel 22.

On conçoit ainsi que l'appareil auxiliaire 20 selon l'invention permet une meilleure surveillance du disjoncteur 18, notamment la détermination de la cause d'un déclenchement en cas de détection du déclenchement du disjoncteur 18 auquel l'appareil auxiliaire 20 est couplé mécaniquement.

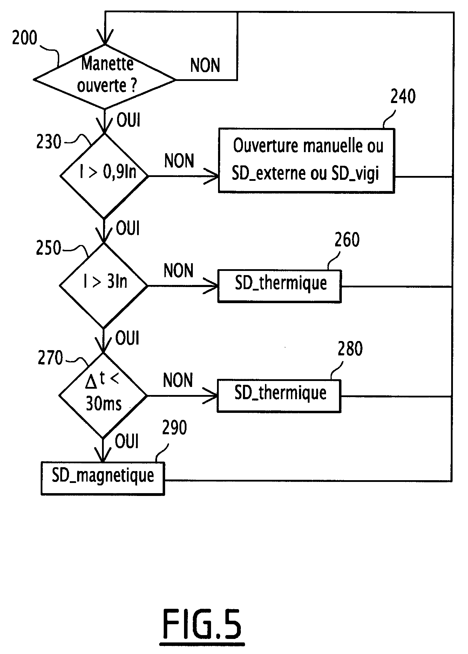

La figure 5 illustre une première variante du procédé de détermination décrit précédemment en regard de la figure 3. Selon cette première variante, la position du premier organe mécanique de sortie 30 n'est pas prise en compte, et l'appareil auxiliaire 20 ne comporte pas nécessairement le premier moyen de couplage 38.

L'étape initiale 200 du procédé de détermination selon cette première variante est identique à l'étape 100, et l'application de détermination 62 passe ensuite directement à l'étape 230.

Lors de l'étape 230, identique à l'étape 130 décrite précédemment, le logiciel de comparaison 66 compare l'intensité I mesurée par le capteur de courant 36 avec la première valeur de seuil S1 afin de déterminer si l'ouverture du disjoncteur 18 est d'origine externe (manuelle ou auxiliaire) ou due à la détection d'une surcharge ou d'un court-circuit par effet thermique.

La première valeur de seuil S1 est fonction de la courbe de déclenchement 135 du disjoncteur 18, visible sur la figure 4. La première valeur de seuil S1 est, par exemple égale à 0,9 fois l'intensité nominale, notée In.

Si le résultat de la comparaison de l'intensité mesurée I avec la première valeur de seuil S1 est négatif, c'est-à-dire si l'intensité mesurée I est inférieure ou égale à la première valeur de seuil S1, alors le disjoncteur 18 se trouve dans une première zone A1, visible sur la figure 4. L'application de détermination 62 en conclut lors de l'étape 240 que l'ouverture du disjoncteur 18 est due à la réception d'un signal de commande du déclenchement, tel qu'une fuite de courant à la terre détectée par le déclencheur différentiel 22 (signal SD_Vigi) ou bien un déclenchement provoqué par un auxiliaire externe au disjoncteur 18 (signal SD_externe), ou encore une ouverture manuelle.

Sinon, c'est-à-dire si la valeur de l'intensité mesurée I est supérieure à la première valeur de seuil S1, alors l'application de détermination 62 passe à l'étape 250 au cours de laquelle le logiciel de comparaison 66 compare l'intensité mesurée I avec la deuxième valeur de seuil S2.

La suite du procédé de détermination selon cette première variante est alors identique à celle du procédé de détermination de la figure 3, et les étapes 250, 260, 270, 280 et 290 sont respectivement identiques aux étapes 150, 160, 170, 180 et 190, les mêmes causes d'ouverture qu'aux étapes 160, 180 ou 190 étant déterminées aux étapes 260, 280 ou 290 par l'application de détermination 62.

A l'issue des étapes 240, 260, 280 ou 290, l'application de détermination 62 retourne à l'étape initiale 200.

L'appareil auxiliaire 20 selon l'invention permet ainsi de déterminer la cause de l'ouverture détectée pour le disjoncteur électrique 18 parmi les différentes causes possibles à savoir un court-circuit, une surcharge, un déclenchement externe (manuel ou par un appareil auxiliaire), tout en utilisant seulement le deuxième moyen de couplage 48 parmi les deux moyens de couplage 38, 48 possibles.

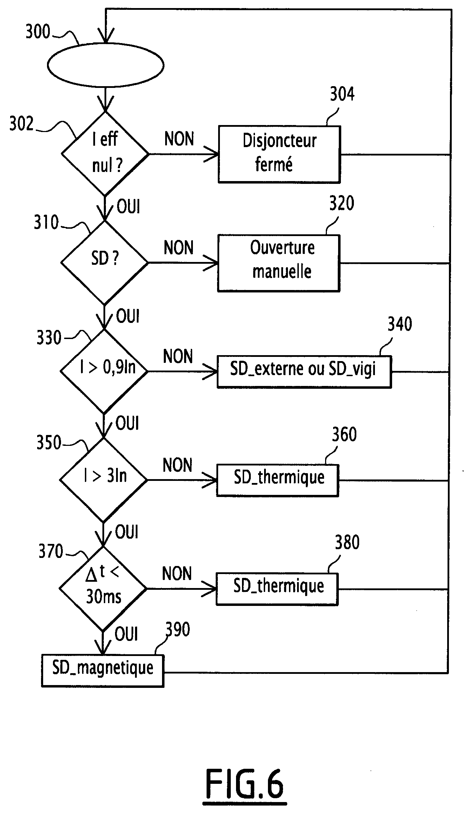

La figure 6 illustre une deuxième variante du procédé de détermination décrit précédemment en regard de la figure 3. Selon cette deuxième variante, la position du deuxième organe mécanique de sortie 32 n'est pas prise en compte, et l'appareil auxiliaire 20 ne comporte pas nécessairement le deuxième moyen de couplage 48.

L'étape initiale 300 du procédé de détermination selon cette deuxième variante est une étape de mesure et d'acquisition des valeurs de courant et de tension, et l'application de détermination 62 passe ensuite à l'étape 302.

En complément, l'application de détermination 62 comporte un deuxième logiciel de calcul, non représenté, le deuxième logiciel de calcul étant propre à calculer une valeur efficace du courant I_{eff}.

Lors de l'étape 302, le deuxième logiciel de calcul calcule la valeur efficace du courant I_{eff}, et détermine si celle-ci est nulle à une tolérance près.

Si la valeur efficace du courant I_{eff} n'est pas nulle, alors l'application de détermination 62 en déduit lors de l'étape 304 que le disjoncteur 18 est toujours à l'état fermé, et retourne à l'étape initiale 300.

Sinon, l'application de détermination 62 passe à l'étape 310 qui est identique à l'étape 110 décrite précédemment.

La suite du procédé de détermination selon cette deuxième variante est alors identique à celle du procédé de détermination selon la figure 3, et les étapes 320, 330, 340, 350, 360, 370, 380 et 390 sont respectivement identiques aux étapes 120, 130, 140, 150, 160, 170, 180 et 190, les mêmes causes d'ouverture qu'aux étapes 120, 140, 160, 180 ou 190 étant déterminées aux étapes 320, 340, 360, 380 ou 390 par l'application de détermination 62.

A l'issue des étapes 320, 340, 360, 380 ou 390, l'application de détermination 62 retourne à l'étape initiale 300.

L'appareil auxiliaire 20 selon l'invention permet ainsi de déterminer la cause de l'ouverture détectée pour le disjoncteur électrique 18 parmi les différentes causes possibles à savoir un court-circuit, une surcharge, un déclenchement externe (manuel ou par un appareil auxiliaire), tout en utilisant seulement le premier moyen de couplage 38 parmi les deux moyens de couplage 38, 48 possibles.

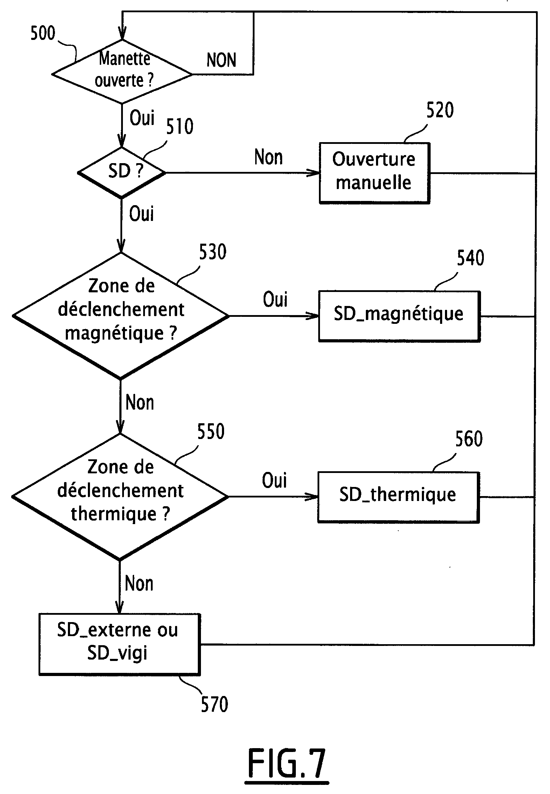

La figure 7 illustre un deuxième mode de réalisation du procédé de détermination pour lequel les éléments analogues au premier mode de réalisation, décrits précédemment, sont repérés par des références identiques, et ne sont pas décrits à nouveau.

Selon ce deuxième mode de réalisation, le procédé de détermination est basé sur la transposition en énergie de la courbe de déclenchement de la figure 4, afin d'obtenir une courbe représentant l'énergie en fonction du temps. L'énergie calculée selon ce deuxième mode de réalisation est proportionnelle à la somme suivante :
Σ I².Δt, où Δt est une période d'échantillonnage.

La courbe est calculée régulièrement sur des fenêtres glissantes représentant chacune des périodes de temps différentes au cours desquelles l'énergie est cumulée. Ces calculs d'énergie en fonction du temps permettent de représenter l'énergie circulant dans le disjoncteur 18 pour des périodes de temps comprises entre 0 seconde et un une période prédéterminée, telle qu'une durée de 2 heures.

L'application de détermination 62 comporte un troisième logiciel de calcul apte à calculer une énergie E(t) à un instant t, puis apte à déterminer si l'énergie E(t) calculée à l'instant t correspond à une zone de déclenchement magnétique, à une zone de déclenchement thermique, ou encore à une autre zone de fonctionnement du disjoncteur 18.

L'étape initiale 500 du procédé de détermination selon cette troisième variante est identique à l'étape initiale 100, et l'application de détermination 62 passe ensuite directement à l'étape 510 qui est identique à l'étape 110 du procédé de la figure 3.

Si, lors de l'étape 510, l'information de signalisation défaut n'est pas présente, c'est-à-dire si la barre de déclenchement 30 est en position d'opération, alors l'application de détermination 62 conclut lors de l'étape 520 que l'ouverture du disjoncteur 18 est due à une ouverture manuelle. Sinon, si l'information SD est présente, c'est-à-dire si la barre de déclenchement 30 est en position d'arrêt, alors l'application de détermination 62 passe à l'étape 530.

Lors de l'étape 530, le troisième logiciel calcule l'énergie E(t) à l'instant t, et détermine l'énergie calculée correspond à la zone de déclenchement magnétique. Le cas échéant, l'application de détermination 62 conclut lors de l'étape 540 que l'ouverture du disjoncteur 18 s'est produite via un déclenchement par effet magnétique, et renvoie alors une information SD_magnétique. Dans ce cas, la cause de l'ouverture du disjoncteur 18 est un court-circuit.

Sinon, c'est-à-dire si l'énergie calculée E(t) ne correspond pas à la zone magnétique, alors le troisième logiciel de calcul détermine, lors de l'étape 550, si l'énergie calculée correspond à la zone de déclenchement thermique. Le cas échéant, l'application de détermination 62 en conclut lors de l'étape 560 que la cause de l'ouverture est une surcharge, le disjoncteur 18 étant alors déclenché par effet thermique, et l'application de détermination 62 renvoie l'information SD_thermique.

Sinon, c'est-à-dire si l'énergie calculée E(t) ne correspond pas non plus à la zone thermique, alors l'application de détermination 62 en conclut lors de l'étape 570 que l'ouverture du disjoncteur 18 est due à la réception d'un signal de commande du déclenchement, tel qu'une fuite de courant à la terre détectée par le déclencheur différentiel 22 (signal SD_Vigi) ou bien un déclenchement provoqué par un auxiliaire externe au disjoncteur 18 (signal SD_externe).

A l'issue des étapes 520, 540, 560 ou 570, l'application de détermination 62 retourne à l'étape initiale 500.

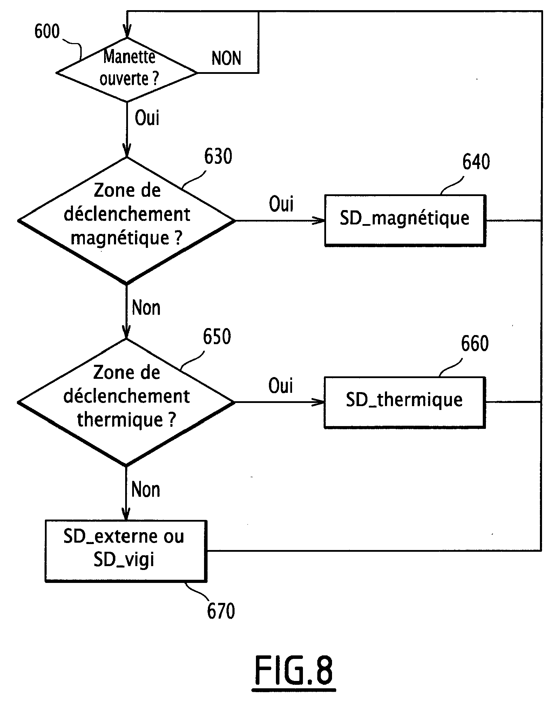

La figure 8 illustre une première variante du procédé de détermination selon le deuxième mode de réalisation décrit précédemment en regard de la figure 7. Selon cette première variante, la position du premier organe mécanique de sortie 30 n'est pas prise en compte, et l'appareil auxiliaire 20 ne comporte pas nécessairement le premier moyen de couplage 38.

L'étape initiale 600 du procédé de détermination selon cette première variante est identique à l'étape 500, et l'application de détermination 62 passe ensuite directement à l'étape 630.

Lors de l'étape 630, identique à l'étape 530 décrite précédemment, le troisième logiciel calcule l'énergie E(t) à l'instant t, et détermine l'énergie calculée correspond à la zone de déclenchement magnétique. Le cas échéant, l'application de détermination 62 conclut lors de l'étape 540 que l'ouverture du disjoncteur 18 s'est produite via un déclenchement par effet magnétique, et renvoie alors une information SD_magnétique. Dans ce cas, la cause de l'ouverture du disjoncteur 18 est un court-circuit.

Sinon, c'est-à-dire si l'énergie calculée E(t) ne correspond pas à la zone magnétique, alors le troisième logiciel de calcul détermine, lors de l'étape 650, si l'énergie calculée correspond à la zone de déclenchement thermique.

La suite du procédé de détermination selon cette première variante relative au deuxième mode de réalisation est alors identique à celle du procédé de détermination de la figure 7, et les étapes 650, 660 et 670 sont respectivement identiques aux étapes 550, 560 et 570, les mêmes causes d'ouverture qu'aux étapes 540, 560 ou 570 étant déterminées aux étapes 640, 660 ou 670par l'application de détermination 62.

A l'issue des étapes 640, 660 ou 670, l'application de détermination 62 retourne à l'étape initiale 600.

L'appareil auxiliaire 20 selon l'invention permet ainsi de déterminer la cause de l'ouverture détectée pour le disjoncteur électrique 18 parmi les différentes causes possibles à savoir un court-circuit, une surcharge, un déclenchement externe (manuel ou par un appareil auxiliaire), tout en utilisant seulement le deuxième moyen de couplage 48 parmi les deux moyens de couplage 38, 48 possibles.

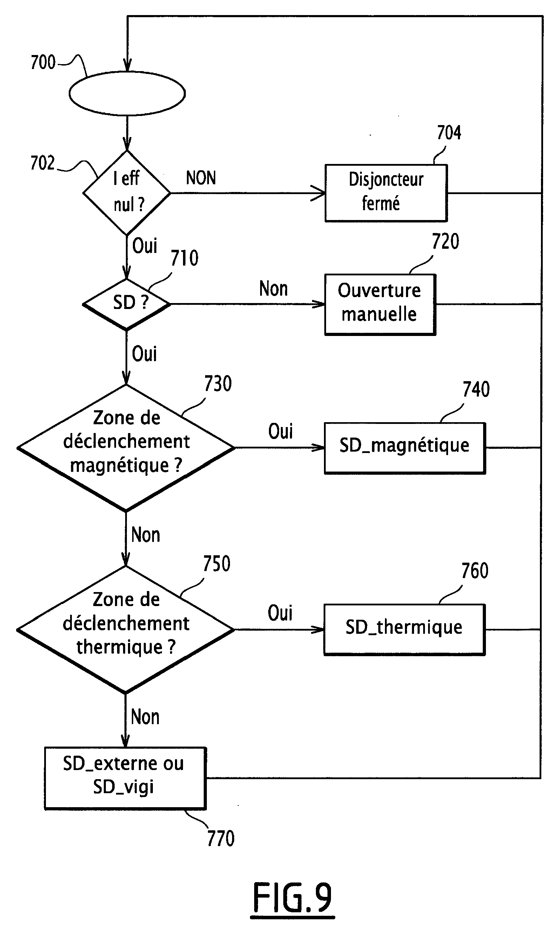

La figure 9 illustre une deuxième variante du procédé de détermination selon le deuxième mode de réalisation décrit précédemment en regard de la figure 7. Selon cette deuxième variante, la position du deuxième organe mécanique de sortie 32 n'est pas prise en compte, et l'appareil auxiliaire 20 ne comporte pas nécessairement le deuxième moyen de couplage 48.

L'étape initiale 700 du procédé de détermination selon cette deuxième variante est une étape de mesure et d'acquisition des valeurs de courant et de tension, et l'application de détermination 62 passe ensuite à l'étape 702.

En complément, l'application de détermination 62 comporte un deuxième logiciel de calcul, non représenté, le deuxième logiciel de calcul étant propre à calculer une valeur efficace du courant I_{eff}.

Lors de l'étape 702, le deuxième logiciel de calcul calcule la valeur efficace du courant I_{eff}, et détermine si celle-ci est nulle à une tolérance près.

Si la valeur efficace du courant I_{eff} n'est pas nulle, alors l'application de détermination 62 en déduit lors de l'étape 704 que le disjoncteur 18 est toujours à l'état fermé, et retourne à l'étape initiale 300.

Sinon, l'application de détermination 62 passe à l'étape 710 qui est identique à l'étape 510 décrite précédemment.

La suite du procédé de détermination selon cette deuxième variante est alors identique à celle du procédé de détermination de la figure 7 selon le deuxième mode de réalisation, et les étapes 720, 730, 740, 750, 760 et 770 sont respectivement identiques aux étapes 520, 530, 540, 550, 560 et 570, les mêmes causes d'ouverture qu'aux étapes 520, 540, 560 ou 570 étant déterminées aux étapes 720, 740, 760 ou 770 par l'application de détermination 62.

A l'issue des étapes 720, 740, 760 ou 770, l'application de détermination 62 retourne à l'étape initiale 700.

L'appareil auxiliaire 20 selon l'invention permet ainsi de déterminer la cause de l'ouverture détectée pour le disjoncteur électrique 18 parmi les différentes causes possibles à savoir un court-circuit, une surcharge, un déclenchement externe (manuel ou par un appareil auxiliaire), tout en utilisant seulement le premier moyen de couplage 38 parmi les deux moyens de couplage 38, 48 possibles.

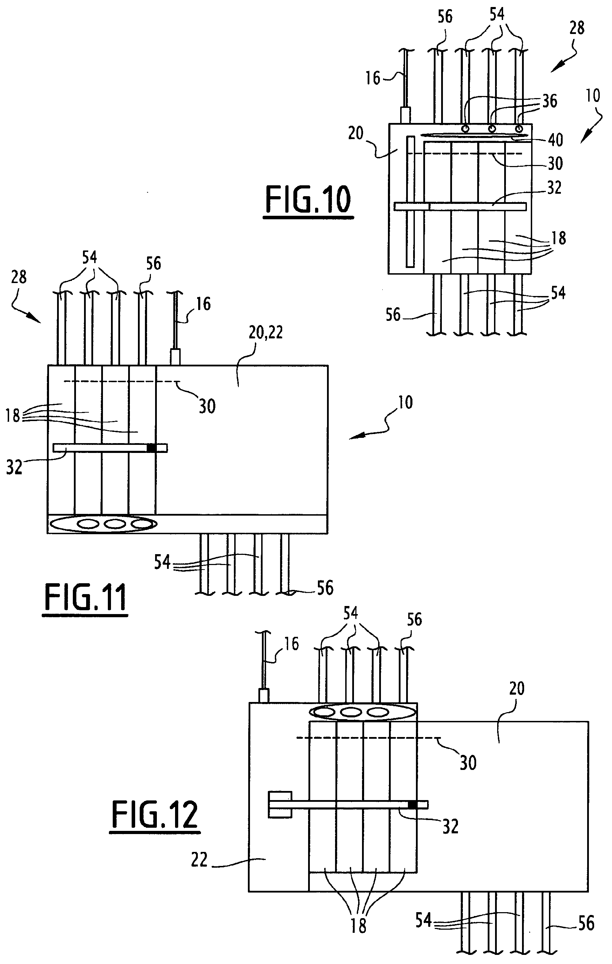

La figure 10 illustre un troisième mode de réalisation de l'invention pour lequel les éléments analogues au premier mode de réalisation, décrits précédemment, sont repérés par des références identiques, et ne sont pas décrits à nouveau.

Selon le troisième mode de réalisation, le courant circulant dans la liaison électrique 28 est un courant triphasé et la liaison électrique 28 comporte trois conducteurs électriques de phase 54 et un conducteur électrique de neutre 56.

Le système électrique 10 comporte alors quatre disjoncteurs 18 formant un disjoncteur tétrapolaire couplés mécaniquement à l'appareil auxiliaire 20.

L'appareil auxiliaire 20 comporte alors trois capteurs de courant de phase 36, chaque capteur de courant de phase 36 étant associé à un conducteur de phase 54 respectif, et un capteur de courant différentiel 40 entourant les trois conducteurs de phase 54 et le conducteur de neutre 56.

L'application de détermination 62 est alors propre à déterminer la cause d'une ouverture détectée sur l'un des quatre disjoncteurs 18 en fonction de chacune des intensités mesurées par les capteurs de courant de phase 36.

Le fonctionnement de ce troisième mode de réalisation pour chaque conducteur de phase 54 est analogue à celui du premier mode de réalisation décrit pour un seul conducteur de phase 54, et n'est pas décrit à nouveau.

Selon ce troisième mode de réalisation, les disjoncteurs 18 sont en complément associés à un déclencheur différentiel 22.

Les avantages de ce troisième mode de réalisation sont identiques à ceux du premier mode de réalisation.

Les figures 11 et 12 illustrent respectivement un quatrième et un cinquième mode de réalisation de l'invention pour lequel les éléments analogues au premier mode de réalisation, décrits précédemment, sont repérés par des références identiques, et ne sont pas décrits à nouveau.

Selon les quatrième et cinquième modes de réalisation, le courant circulant dans la liaison électrique 28 est de manière identique au troisième mode de réalisation un courant triphasé, et la liaison électrique 28 comporte alors trois conducteurs électriques de phase 54 et un conducteur de neutre 56.

Selon les quatrième et cinquième modes de réalisation, l'appareil auxiliaire 20 est disposé à droite des quatre disjoncteurs 18 alors que l'appareil auxiliaire 20 est disposé à gauche des quatre disjoncteurs 18 dans le troisième mode de réalisation représenté sur la figure 10.

On conçoit ainsi que l'appareil auxiliaire 20 selon l'invention permet une meilleure surveillance du disjoncteur 18, notamment la détermination de la cause d'une ouverture en cas de détection de l'ouverture du disjoncteur 18 auquel l'appareil auxiliaire 20 est couplé mécaniquement.

## Revendications

1. Appareil auxiliaire (20) pour disjoncteur électrique (18), le disjoncteur électrique (18) étant, en position ouverte, propre à interrompre la circulation d'un courant électrique dans une liaison électrique (28), la liaison électrique (28) comportant au moins un conducteur électrique (54), le disjoncteur électrique (18) comportant un organe mécanique de sortie (30, 32) mobile entre une position d'opération et une position d'arrêt correspondant à l'interruption de la circulation du courant dans ladite liaison électrique (28),
l'appareil auxiliaire (20) comprenant :
- un moyen (38, 48) de couplage mécanique avec l'organe mécanique de sortie (30, 32), le moyen de couplage mécanique (38, 48) formant moyen de détection de l'ouverture du disjoncteur (18),
**caractérisé en ce qu'**il comprend en outre au moins un capteur de courant (36) propre à mesurer l'intensité (I) du courant circulant dans un conducteur électrique (54) respectif, et un dispositif (62) de détermination d'une cause de l'ouverture détectée, en fonction de l'intensité (I) mesurée par le ou chaque capteur de courant (36), le dispositif de détermination (62) étant relié au moyen de couplage mécanique (38, 48) et au capteur de courant (36).

2. Appareil auxiliaire (20) selon la revendication 1, dans lequel le dispositif de détermination (62) comprend un moyen (66) de comparaison, avec au moins une valeur de seuil prédéterminée (S1, S2), de l'intensité (I) mesurée par le ou chaque capteur de courant (36).

3. Appareil auxiliaire (20) selon la revendication 2, dans lequel le moyen de comparaison (66) est propre à comparer l'intensité mesurée (I) avec une première valeur de seuil (S1) afin de déterminer une première cause d'ouverture et avec une deuxième valeur (S2) de seuil afin de déterminer une deuxième cause d'ouverture.

4. Appareil auxiliaire (20) selon la revendication 2 ou 3, dans lequel le dispositif de détermination (62) comprend un moyen (68) de calcul d'une durée (Δt) pendant laquelle l'intensité mesurée (I) est supérieure à la valeur de seuil prédéterminée (S2).

5. Appareil auxiliaire (20) selon l'une quelconque des revendications 2 à 4, dans lequel le dispositif de détermination (62) comprend un moyen (70) de datation du ou des dépassements de la valeur de seuil prédéterminée par l'intensité mesurée (I) et une mémoire de stockage des dates du ou desdits dépassements.

6. Appareil auxiliaire (20) selon l'une quelconque des revendications précédentes, dans lequel le disjoncteur électrique (18) comprend deux organes mécaniques de sortie (30, 32), un premier organe (30) parmi les deux organes mécaniques de sortie étant mobile en position d'arrêt en cas de surcharge sur la liaison électrique (28) et le deuxième organe (32) étant mobile en position d'arrêt en cas de surcharge sur la liaison électrique (28) ou d'actionnement manuel du disjoncteur électrique (18),
dans lequel l'appareil auxiliaire (20) comprend deux moyens de couplage mécanique (38, 48), un premier moyen (38) parmi les deux moyens de couplage étant couplé mécaniquement avec le premier organe de sortie (30) et le deuxième moyen (48) étant couplé mécaniquement avec le deuxième organe de sortie (32), et
dans lequel le dispositif de détermination (62) est relié aux premier et deuxième moyens de couplage mécanique (38, 48), la cause de l'ouverture étant déterminée en outre en fonction de la position du premier organe mécanique de sortie (30) et de la position du deuxième organe mécanique de sortie (32).

7. Appareil auxiliaire (20) selon l'une quelconque des revendications précédentes, dans lequel l'appareil auxiliaire (20) comprend en outre un capteur de courant différentiel (40), et le dispositif de détermination (62) est propre à déterminer la cause du déclenchement en fonction de l'intensité (I) mesurée par le ou chaque capteur de courant (36) et du courant différentiel (Id) mesuré par le capteur de courant différentiel (40).

8. Système électrique (10) comprenant un disjoncteur électrique (18) et un appareil auxiliaire (20) couplé mécaniquement au disjoncteur électrique (18), le disjoncteur électrique (18) étant, en position ouverte, propre à interrompre la circulation d'un courant électrique dans une liaison électrique (28), la liaison électrique (28) comportant au moins un conducteur électrique (54), le disjoncteur électrique (18) comportant un organe mécanique de sortie (30, 32) mobile entre une position d'opération et une position d'arrêt correspondant à l'interruption de la circulation du courant dans ladite liaison électrique (28), **caractérisé en ce que** l'appareil auxiliaire (20) est conforme à l'une quelconque des revendications précédentes.

9. Système électrique (10) selon la revendication 8, dans lequel le système électrique (10) comprend en outre un déclencheur différentiel (22) disposé entre le disjoncteur électrique (18) et l'appareil auxiliaire (20), l'appareil auxiliaire (20) étant couplé mécaniquement à l'organe mécanique de sortie (30, 32) du disjoncteur électrique (18).

10. Procédé de détermination d'une cause d'une ouverture d'un disjoncteur électrique (18) à l'aide d'un appareil auxiliaire (20), le disjoncteur électrique (18) étant, en position ouverte, propre à interrompre la circulation d'un courant électrique dans une liaison électrique (28), la liaison électrique (28) comportant au moins un conducteur électrique (54), le disjoncteur électrique (18) comportant un organe mécanique de sortie (30, 32) mobile entre une position d'opération et une position d'arrêt correspondant à l'interruption de la circulation du courant dans ladite liaison électrique (28), l'appareil auxiliaire (20) comprenant un moyen (38, 48) de couplage mécanique avec l'organe mécanique de sortie (30, 32),
le procédé comprenant l'étape suivante :
- la détection (100, 110), via le moyen de couplage mécanique (38, 48), de l'ouverture du disjoncteur électrique (18),
le procédé étant **caractérisé en ce qu'**il comprend en outre les étapes suivantes :
- la mesure (130, 150), par l'appareil auxiliaire (20), de l'intensité (I) du courant circulant dans le ou chaque conducteur (54), l'appareil auxiliaire (20) comportant en outre un capteur de courant (36) pour chaque conducteur électrique (54), et
- la détermination (140, 160, 180, 190), par l'appareil auxiliaire (20) et en fonction de l'intensité (I) mesurée par le ou chaque capteur de courant (36), d'une cause de l'ouverture détectée.

11. Procédé selon la revendication 10, dans lequel le disjoncteur électrique (18) comprend deux organes mécaniques de sortie (30, 32), un premier organe (30) parmi les deux organes mécaniques de sortie étant mobile en position d'arrêt en cas de surcharge sur la liaison électrique (28) et le deuxième organe (32) étant mobile en position d'arrêt en cas de surcharge sur la liaison électrique (28) ou d'actionnement manuel du disjoncteur électrique (18),
dans lequel l'appareil auxiliaire (20) comprend deux moyens de couplage mécanique (38, 48), un premier moyen (38) parmi les deux moyens de couplage étant couplé mécaniquement avec le premier organe de sortie (30) et le deuxième moyen (48) étant couplé mécaniquement avec le deuxième organe de sortie (32), et
dans lequel, lors de l'étape de détermination, la cause de l'ouverture est déterminée en outre en fonction de la position du premier organe mécanique de sortie (30) et de la position du deuxième organe mécanique de sortie (32).

## Patentansprüche

1. Zusatzvorrichtung (20) für einen elektrischen Trennschalter (18), wobei der elektrische Trennschalter (18) in der offenen Stellung dazu geeignet ist, den Fluss eines elektrischen Stroms in einer elektrischen Verbindung (28) zu unterbrechen, wobei die elektrische Verbindung (28) mindestens einen elektrischen Leiter (54) aufweist, wobei der elektrische Trennschalter (18) ein mechanisches Ausgangselement (30, 32) hat, das zwischen einer Betriebsstellung und einer Stoppstellung, die der Unterbrechung des Flusses des Stroms in der elektrischen Verbindung (28) entspricht, beweglich ist,
wobei die Zusatzvorrichtung (20) aufweist:
- eine Einrichtung (38, 48) zur mechanischen Kopplung mit dem mechanischen Ausgangselement (30, 32), wobei die mechanische Kopplungseinrichtung (38, 48) eine Erfassungseinrichtung für das Öffnen des Trennschalters (18) bildet,
**dadurch gekennzeichnet, dass** sie darüber hinaus mindestens einen Stromsensor (36), der sich dazu eignet, die Stärke (I) des in einem jeweiligen elektrischen Leiter (54) fließenden Stroms zu messen, und eine Vorrichtung (62) zur Bestimmung einer Ursache für das erfasste Öffnen in Abhängigkeit von der durch den oder jeden Stromsensor (36) gemessenen Stärke (I) aufweist, wobei die Bestimmungsvorrichtung (62) mit der mechanischen Kopplungseinrichtung (38, 48) und dem Stromsensor (36) verbunden ist.

2. Zusatzvorrichtung (20) nach Anspruch 1, wobei die Bestimmungsvorrichtung (62) eine Einrichtung (66) zum Vergleichen der durch den oder jeden Stromsensor (36) gemessenen Stärke (I) mit mindestens einem vorbestimmten Schwellenwert (S1, S2) aufweist.

3. Zusatzvorrichtung (20) nach Anspruch 2, wobei sich die Vergleichseinrichtung (66) dazu eignet, die gemessene Stärke (I) mit einem ersten Schwellenwert (S1), um eine erste Öffnungsursache zu bestimmen, und mit einem zweiten Schwellenwert (S2) zu vergleichen, um eine zweite Öffnungsursache zu bestimmen.

4. Zusatzvorrichtung (20) nach Anspruch 2 oder 3, wobei die Bestimmungsvorrichtung (62) eine Einrichtung (68) zum Berechnen einer Dauer (Δt) aufweist, während der die gemessene Stärke (I) höher ist als der vorbestimmte Schwellenwert (S2).

5. Zusatzvorrichtung (20) nach einem der Ansprüche 2 bis 4, wobei die Bestimmungsvorrichtung (62) eine Einrichtung (70) zur Datierung der Überschreitung/en des vorbestimmten Schwellenwerts durch die gemessene Stärke (I) und einen Speicher zur Hinterlegung der Daten der Überschreitung/en aufweist.

6. Zusatzvorrichtung (20) nach einem der vorhergehenden Ansprüche, wobei der elektrische Trennschalter (18) zwei mechanische Ausgangselemente (30, 32) aufweist, wobei ein erstes Element (30) von den zwei mechanischen Ausgangselementen im Fall einer Überlastung an der elektrischen Verbindung (28) in die Stoppstellung beweglich ist, und das zweite Element (32) im Fall einer Überlastung an der elektrischen Verbindung (28) oder einer manuellen Betätigung des elektrischen Trennschalters (18) in die Stoppstellung beweglich ist,
wobei die Zusatzvorrichtung (20) zwei mechanische Kopplungseinrichtungen (38, 48) aufweist, wobei eine erste Einrichtung (38) von den zwei Kopplungseinrichtungen mechanisch mit dem ersten Ausgangselement (30) gekoppelt wird, und die zweite Einrichtung (48) mechanisch mit dem zweiten Ausgangselement (32) gekoppelt wird, und
wobei die Bestimmungseinrichtung (62) mit der ersten und zweiten mechanischen Kopplungseinrichtung (38, 48) verbunden ist, die Ursache des Öffnens darüber hinaus in Abhängigkeit von der Stellung des ersten mechanischen Ausgangselements (30) und von der Stellung des zweiten mechanischen Ausgangselements (32) bestimmt wird.

7. Zusatzvorrichtung (20) nach einem der vorhergehenden Ansprüche, wobei die Zusatzvorrichtung (20) darüber hinaus einen Differenzstromsensor (40) aufweist und sich die Bestimmungsvorrichtung (62) dazu eignet, die Ursache des Auslösens in Abhängigkeit von der durch den oder jeden Stromsensor (36) gemessenen Stärke (I) oder von dem durch den Differenzstromsensor (40) gemessenen Differenzstrom (Id) zu bestimmen.

8. Elektrisches System (10) mit einem elektrischen Trennschalter (18) und einer mechanisch mit dem elektrischen Trennschalter (18) gekoppelten Zusatzvorrichtung (20), wobei der elektrische Trennschalter (18) in der offenen Stellung dazu geeignet ist, den Fluss eines elektrischen Stroms in einer elektrischen Verbindung (28) zu unterbrechen, wobei die elektrische Verbindung (28) mindestens einen elektrischen Leiter (54) aufweist, wobei der elektrische Trennschalter (18) ein mechanisches Ausgangselement (30, 32) hat, das zwischen einer Betriebsstellung und einer Stoppstellung, die der Unterbrechung des Flusses des Stroms in der elektrischen Verbindung (28) entspricht, beweglich ist, **dadurch gekennzeichnet, dass** die Zusatzvorrichtung (20) einem der vorhergehenden Ansprüche entspricht.

9. Elektrisches System (10) nach Anspruch 8, wobei das elektrische System (10) darüber hinaus einen Differenzauslöser (22) aufweist, der zwischen dem elektrischen Trennschalter (18) und der Zusatzvorrichtung (20) angeordnet ist, wobei die Zusatzvorrichtung (20) mechanisch mit dem mechanischen Ausgangselement (30, 32) des elektrischen Trennschalters (18) gekoppelt ist.

10. Verfahren zum Bestimmen einer Ursache eines Öffnens eines elektrischen Trennschalters (18) mittels einer Zusatzvorrichtung (20), wobei der elektrische Trennschalter (18) in der offenen Stellung dazu geeignet ist, den Fluss eines elektrischen Stroms in einer elektrischen Verbindung (28) zu unterbrechen, wobei die elektrische Verbindung (28) mindestens einen elektrischen Leiter (54) aufweist, wobei der elektrische Trennschalter (18) ein mechanisches Ausgangselement (30, 32) hat, das zwischen einer Betriebsstellung und einer Stoppstellung, die der Unterbrechung des Flusses des Stroms in der elektrischen Verbindung (28) entspricht, beweglich ist, wobei die Zusatzvorrichtung (20) eine Einrichtung (38, 48) zur mechanischen Kopplung mit dem mechanischen Ausgangselement (30, 32) aufweist,
wobei das Verfahren den folgenden Schritt umfasst:
- die Erfassung (100, 110) des Öffnens des elektrischen Trennschalters (18) über die mechanische Kopplungseinrichtung (38, 48),
wobei das Verfahren **dadurch gekennzeichnet ist, dass** es darüber hinaus die folgenden Schritte umfasst:
- das Messen (130, 150) der Stärke (I) des in dem oder jedem Leiter (54) fließenden Stroms durch die Zusatzvorrichtung (20), wobei die Zusatzvorrichtung (20) darüber hinaus einen Stromsensor (36) für jeden elektrischen Leiter (54) aufweist, und
- die Bestimmung (140, 160, 180, 190) einer Ursache der erfassten Öffnung durch die Zusatzvorrichtung (20) und in Abhängigkeit von der durch den oder jeden Stromsensor (36) gemessenen Stärke (I).

11. Verfahren nach Anspruch 10, wobei der elektrische Trennschalter (18) zwei mechanische Ausgangselemente (30, 32) aufweist, wobei ein erstes Element (30) von den zwei mechanischen Ausgangselementen im Fall einer Überlastung an der elektrischen Verbindung (28) in die Stoppstellung beweglich ist, und das zweite Element (32) im Fall einer Überlastung an der elektrischen Verbindung (28) oder einer manuellen Betätigung des elektrischen Trennschalters (18) in die Stoppstellung beweglich ist,
wobei die Zusatzvorrichtung (20) zwei mechanische Kopplungseinrichtungen (38, 48) aufweist, wobei eine erste Einrichtung (38) von den zwei Kopplungseinrichtungen mechanisch mit dem ersten Ausgangselement (30) gekoppelt wird, und die zweite Einrichtung (48) mechanisch mit dem zweiten Ausgangselement (32) gekoppelt wird, und
wobei im Bestimmungsschritt die Ursache des Öffnens darüber hinaus in Abhängigkeit von der Stellung des ersten mechanischen Ausgangselements (30) und von der Stellung des zweiten mechanischen Ausgangselements (32) bestimmt wird.

## Claims

1. An auxiliary apparatus (20) for an electric circuit breaker (18), the electric circuit breaker (18) being, in an open position, able to interrupt the circulation of a current in an electrical connection (28), the electrical connection (28) including at least one electrical conductor (54), the electric circuit breaker (18) including a mechanical output member (30, 32), movable between an operating position and a stop position corresponding to the interruption of the circulation of the current in said electrical connection (28),
the auxiliary apparatus (20) comprising:
- a mechanical coupling mean (38, 48) for mechanical coupling with the mechanical output member (30, 32), the mechanical coupling mean (38, 48) forming mean for detecting the opening of the circuit breaker (18),
**characterized in that** it further comprises at least one current sensor (36) capable of measuring the intensity (I) of the current circulating in a respective electrical conductor (54), and a determining device (62) for determining a cause of the detected opening, based on the intensity (I) measured by the or each current sensor (36), the determining device (62) being connected to the mechanical coupling mean (38, 48) and the current sensor (36).

2. The auxiliary apparatus (20) according to claim 1, wherein the determining device (62) comprises a comparison means (66) for comparing the intensity (I) measured by the or each current sensor (36) with at least one predetermined threshold value (S1, S2).

3. The auxiliary apparatus (20) according to claim 2, wherein the comparison mean (66) is capable of comparing the measured intensity (I) with a first threshold value (S1) in order to determine a first cause of opening and with a second threshold value (S2) in order to determine a second cause of opening.

4. The auxiliary apparatus (20) according to claim 2 or 3, wherein the determining device (62) comprises a computing mean (68) for computing a duration (Δt) during which the measured intensity (I) is above a predetermined threshold value (S2).

5. The auxiliary apparatus (20) according to any one of claims 2 to 4, wherein the determining device (62) comprises a dating mean (70) for dating the excess of the predetermined threshold value by the measured intensity (I) and a memory for storing the dates of said excess.

6. The auxiliary apparatus (20) according to any one of the preceding claims, wherein the electric circuit breaker (18) comprises two mechanical output members (30, 32), a first member (30) among the two mechanical output members being movable in the stop position in case of overload on the electrical connection (28) and the second member (32) being able to be moved into the stop position in case of overload on the electrical connection (28) or manual actuation of the electric circuit breaker (18),
wherein the auxiliary apparatus (20) comprises two mechanical coupling means (38, 48), a first mean (38) among the two coupling means being mechanically coupled with the first output member (30) and the second mean (48) being mechanically coupled with the second output member (32), and
wherein the determining device (62) is connected to the first and second mechanical coupling (38, 48) means, the cause of the opening being determined based furthermore on the position of the first mechanical output member (30) and the position of the second mechanical output member (32).

7. The auxiliary apparatus (20) according to any one of the preceding claims, wherein the auxiliary apparatus (20) further comprises a differential current sensor (40), and the determination device (62) is capable of determining the cause of opening based on the intensity (I) measured by the or each current sensor (36) and the differential current (Id) measured by the differential current sensor (40).

8. An electric system (10) comprising an electric circuit breaker (18) and an auxiliary apparatus (20) mechanically coupled to the electric circuit breaker (18), the electric circuit breaker (18) being, in an open position, capable of interrupting the circulation of an electric current in an electrical connection (28), the electrical connection (28) including at least one electrical conductor (54), the electric circuit breaker (18) including a mechanical output member (30, 32) movable between an operating position and a stop position corresponding to the interruption of the circulation of current in said electrical connection (28), **characterized in that** the auxiliary apparatus (20) is according to any one of the preceding claims.

9. The electric system (10) according to claim 8, wherein the electric system (10) further comprises a differential trigger (22) positioned between the electric circuit breaker (18) and the auxiliary apparatus (20), the auxiliary apparatus (20) being mechanically coupled to the mechanical output member (30, 32) of the electric circuit breaker (18).

10. A method for determining a cause of opening of an electric circuit breaker (18) using an auxiliary apparatus (20), the electric circuit breaker (18) being, in an open position, capable of interrupting the circulation of an electric current in an electrical connection (28), the electrical connection (28) including at least one electric conductor (54), the electric circuit breaker (18) having a mechanical output member (30, 32), movable between an operating position and a stop position corresponding to the interruption of the circulation of current in said electrical connection (28), the auxiliary apparatus (20) comprising a mechanical coupling mean (38, 48) for mechanical coupling with the mechanical output member (30, 32),
the method comprising the following step:
- the detection (100, 110), via the mechanical coupling mean (38, 48), of the opening of the electric circuit breaker (18),
the method being **characterized in that** it further comprises the following steps:
- the measurement (130, 150), by the auxiliary apparatus (20), of the intensity (I) of the current circulating in the or each conductor (54), the auxiliary apparatus (20) further including a current sensor (36) for each electrical conductor (54), and
- the determination (140, 160, 180, 190), by the auxiliary apparatus (20) and based on the intensity (I) measured by the or each current sensor (36), of a cause of the detected opening.

11. The method according to claim 10, wherein the electric circuit breaker (18) comprises two mechanical output members (30, 32), a first member (30) among the two mechanical output members being able to be moved to the stopped position in case of an overload on the electrical connection (28) and the second member (32) being movable to the stopped position in case of an overload on the electrical connection (28) or manual actuation of the electric circuit breaker (18),
wherein the auxiliary apparatus (20) comprises two mechanical coupling means (38, 48), a first mean (38) among the two coupling means being mechanically coupled with the first output member (30) and the second mean (48) being mechanically coupled with the second output member (32), and
wherein, during the determination step, the cause of the opening is determined based furthermore on the position of the first mechanical output member (30) and on the position of the second mechanical output member (32).
